# EUROPEAN PATENT APPLICATION

(11) **EP 2 418 773 A1**
(43) Date of publication of application: **15.02.2012**
(21) Application number: 10171108.3
(22) Date of filing: 28.07.2010
(51) Int. Cl.: H03H 17/02, H03H 17/06

(54) **Glitch-free switchable FIR-filter**

(71) Applicant: Brandenburgische Technische Universität Cottbus, 03046 Cottbus (DE)
(72) Inventor: Mueller-Roemer, Johannes Sebastian, 03050 Cottbus (DE); Szegvari, Piotr, 03048 Cottbus (DE); Hentschel, Christian, 03042 Cottbus (DE)
(74) Representative: Gulde Hengelhaupt Ziebig & Schneider

(57) **Abstract**

A digital filter having (30) an input and an output and comprising a first FIR-filter (31) having m stages and a second FIR-filter (32) having n stages and an input connected to the input of the digital filter, wherein m and n are positive integers and n is greater than m, and wherein the output of the digital filter is selectively connectable through a switch (33) to one of an output of the first FIR-filter and an output of the second FIR-filter in accordance with a filter selection signal. The digital filter further comprises an input delay buffer (34) connected between the input of the digital filter and an input of the first FIR-filter and having k stages, wherein k is a nearest integer from (n - m)/2.

## Description

### Technical Field of the Invention

The invention deals with a digital filter which may be switched from one FIR-characteristic to another without the occurrence of glitches or other types of discontinuities, a corresponding method of digital filtering and a computer-readable medium comprising a computer program for carrying out the method of digital filtering.

### Background of the Invention

In the field of signal processing there is a strong tendency towards software-based solutions. Digital filters and other parts of the signal processing chain are more and more realised in the form of software operations which have equivalent functions as their hardware counterparts. While a digital signal processor (DSP) required to run the software operations is a comparatively complex and therefore costly piece of hardware, the much higher flexibility of such a solution compensates for the increased cost. E.g. it can be possible to change filter coefficients of a digital filter on-the-fly in order to adapt the signal processing to changed environmental parameters or the like. In this way it may e.g. become possible to flexibly serve a certain number of communication lines with high-quality signal processing or a much higher number of communication lines with relatively lower quality signal processing depending on the number of people using the service at a certain time. Thus, if the overall system load changes, so may the characteristics of at least parts of the signal processing chain in order to adapt to the available processing capacities. More specifically, it may be desirable to change the filter coefficients and even the number of filter coefficients of a digital filter and thus the number of computations required to perform the filtering operation of the digital filter. Such a filter may be referred to as being a "dynamically scalable filter".

In general in the scope of this document a digital filter realised in hardware (such as a dedicated hardware or a programmable hardware such as an FPGA) is to be understood to be equivalent to a corresponding software function which will be interchangably referred to as "digital filters" or "digital filter functions" and the like.

Two ways of on-the-fly switching between different filter characteristics may be conceived. Firstly, the filter coefficients and the number of filter coefficients are changed abruptly which leads to discontinuities in the output signal which are perceived as disruptions in the signal. Secondly, the signal is being processed by two filters at the same time and the output signal is generated by cross-fading from the output signal of a first one of the two filters to the output signal of the other one. While this can eliminate the problems arising from rapid switching, this method requires at least twice the computing power needed for normal operation because in addition to the cross-fading operation two filter functions have to be executed in parallel.

The invention is based on the insight that a digital filter and a method of digital filtering are desirable that allow for on-the-fly switching from one filter characteristic to another without the introduction of discontinuities into the output signal and without requiring the overhead of computing both filter functions and the cross-fading at the same time.

### Summary of the Invention

A first aspect of the invention therefore provides a digital filter having an input and an output and comprising a first FIR-filter (finite impluse-response filter) having m stages and a second FIR-filter having n stages and an input connected to the input of the digital filter, wherein m and n are positive integers and n is greater than m, and wherein the output of the digital filter is selectively connectable to one of an output of the first FIR-filter and an output of the second FIR-filter in accordance with a filter selection signal. According to the invention the digital filter comprises an input delay buffer connected between the input of the digital filter and an input of the first FIR-filter and having k stages, wherein k is a nearest integer from (n - m)/2.

The digital filter of the invention has an advantage over the prior art in that instantaneous switching between the first FIR-filter and the second FIR-filter is possible without causing any discontinuity in the output signal. The input delay buffer compensates for the different delays of the two FIR-filters that arise from the different number of stages of the filters. Since FIR-filters have a depth or memory of a number of samples equal to the number of stages of the FIR-filter, the compensation caused by the input delay buffer assures that both FIR-filters will output samples resulting from the same set of input samples. Of course, only one FIR-filter needs to be active at any time thereby saving power consumption. If the digital filter is realised using a digital signal processor or similar means, only one filter function needs to be computed thereby keeping the required computing power at a minimum. In the scope of this document a "stage" may be interpreted as being a ,filter tap".

Preferably both m and n are either odd numbers or even numbers and k is (n - m)/2. In this case the different delays of the two FIR-filters can be fully compensated because then (n - m) must be an even number such that (n - m)/2 yields an integer value. If one of m and n is an odd number while the other is an even number, the difference of n and m will be an odd number. This leads to a remaining delay difference of half an input sample or an overcompensation of the delay difference by half an input sample. While this small remaining delay may be tolerable, optimal compensation will be achieved when both m and n are either odd numbers or even numbers.

Alternatively the digital filter may further include an oversampling unit having an input connected to the input of the digital filter and an output connected to the input of the input delay buffer and to the input of the second FIR-filter. The oversampling unit may be adapted to oversample an input data stream. A first one of m or n may be an odd number and a remaining one of m or n may be an even number. Since oversampling is applied, preferably by any suitable even oversampling ratio such as 2, it becomes possible to use an input delay buffer having a fractional delay when compared to the input sampling rate of the digital filter. Thus, the difference between the delays of the two FIR-filters can be fully compensated even if m and n are not both odd or even numbers.

In a preferred embodiment the first FIR-filter and the second FIR-filter are linear-phase FIR-filters. In this embodiment the delay caused by the filters is independent from the frequency of a signal. Thus, the delay differences may be optimally compensated for all signal frequencies.

In more detail, the first FIR-filter may comprise m+1 filter coefficients. An (i)th filter coefficient may be equal to an (m+2-i)th filter coefficient. The second FIR-filter may comprise n+1 filter coefficients and an (j)th filter coefficient may be equal to an (n+2-j)th filter coefficient. The resulting FIR-filter are symmetric and known to show phase-linear behaviour which yields the above-mentioned advantages.

The first FIR-filter and the second FIR-filter may be low-pass filters. Such filters may e.g. be used for decimation (conversion from a relatively higher sampling rate to a relatively lower sampling rate). In such a case it is possible to apply the digital filter to every Mth input sample where M is the ratio of the input sampling rate over the output sampling rate. M is an integer number.

Preferably a cut-off frequency of the first FIR-filter differs by less than thirty percent from a cut-off frequency of the second FIR-filter. More preferably the cut-off frequency of the first FIR-filter is equal to the cut-off frequency of the second FIR-filter. If the cut-off frequencies of the first FIR-filter and of the second FIR-filter are at least substantially equal to each other, the major remaining differences will be the ripple in the pass-band and the edge steepness. Generally, a filter showing a steep edge and low ripple in the pass-band will be more complex and more computing intensive than a filter showing less edge steepness and more ripple in the pass-band. In a given application it may become necessary to switch from a high-quality filter having low ripple and a steep edge to a less computing intensive filter because of an increased overall system load or vice versa in case of decreasing system load. If the cut-off frequencies of both FIR-filters are at least substantially equal to each other, the output signals of the two filters will comprise similar spectral components and therefore be similar to each other thereby making the rapid switching from one filter to the other imperceptible.

The digital filter may be an interpolation filter having an output sampling rate L times higher than an input sampling rate of the digital filter, wherein L is an integer number. In this case k is most preferably chosen to be an integer multiple of L. The digital filter can also be a decimation filter having an output sampling rate M times lower than an input sampling, wherein M is an integer multiple of k. Interpolation and decimation can be combined in the filter of the invention in order to achieve a wider range of possible ratios between the overall input sampling rate and the overall output sampling rate of L/M.

A second aspect of the invention provides a method of digital filtering an input data stream having an input sampling rate to create an output data stream. The method comprises:
filtering the input data stream with a first FIR-filter function having m stages, wherein m is a positive interger;
filtering the input data stream with a second FIR-filter function having n stages, wherein n is a positive integer greater than m; and
selectively outputting an output of the first FIR-filter function or the second FIR-filter function in accordance with a filter selection signal.
According to the invention the input data stream is delayed by k input samples, wherein k is a nearest integer from (n - m)/2, before being passed to the first FIR-filter function.

As explained above, preferably both m and n are either odd numbers or even numbers such that k becomes exactly (n - m)/2.

The first FIR-filter function and the second FIR-filter function may be linear-phase FIR-filter functions. The first FIR-filter function may comprise m+1 filter coefficients and an (i)th filter coefficient may be equal to an (m+2-i)th filter coefficient. In addition the second FIR-filter function may comprise n+1 filter coefficients and a (j)th coefficient may be equal to an (n+2-j)th filter coefficient.

Preferably the first FIR-filter function and the second FIR-filter function are low-pass filter functions. A cut-off frequency of the first FIR-filter function may differ by less than thirty percent from a cut-off frequency of the second FIR-filter function. More preferably the cut-off frequency of the first FIR-filter function is equal to the cut-off frequency of the second FIR-filter function.

The method may comprise interpolating the input data stream to create an output data stream having an output sampling rate L times higher than the input sampling rate, wherein L is an integer number and k is an integer multiple of L. The method may also comprise decimating the input data stream to create an output data stream having an output sampling rate M times lower than the input sampling rate, wherein M is an integer multiple of k. Interpolation and decimation can be combined in the method of the invention in order to achieve a wider range of possible ratios between the overall input sampling rate and the overall output sampling rate of L/M.

A third aspect of the invention provides a computer-readable storage medium storing a computer-executable program which causes a computer executing the computer-executable program to carry out the method of the second aspect of the invention.

### Short Description of the Figures

The invention will be described in more detail referring to a plurality of figures of which:
Fig. 1 shows an FIR-filter in the first standard form;
Fig. 2 shows a first embodiment of the invention;
Fig. 3 shows a first preferred embodiment of the invention;
Fig. 4 shows a second preferred embodiment of the invention;
Fig. 5 shows a third preferred embodiment of the invention; and
Fig. 6 shows a fourth preferred embodiment of the invention.

### Detailed Description of the Figures

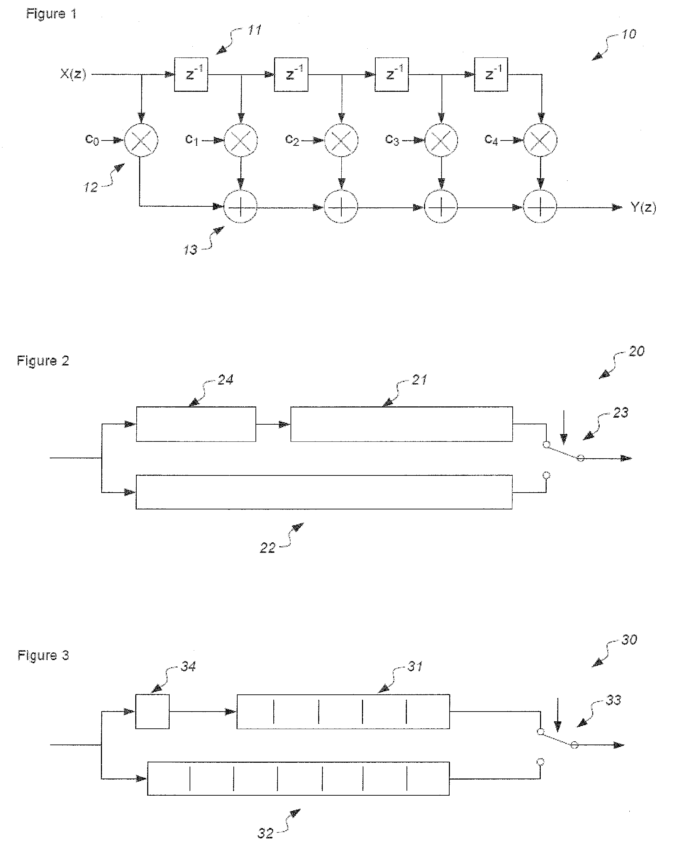

Fig. 1 shows an FIR-filter 10 in the first standard form. Generally each FIR-filter can be constructed using different structures among which the first and second standard forms are the most popular ones. In the example of Fig. 1 a time- and amplitude-discrete input signal x whose z-transform is denoted as X(z) will be passed to a plurality of delays 11 which are series-connected and which each delay the samples of the input signal x by one clock cycle (commonly illustrated by z⁻¹ which is the z-transform of a unit delay). The series-connected delays 11 will also be referred to as "stages". The inputs and outputs of the delays 11 are connected to a plurality of multipliers 12 which multiply the corresponding sample passed to the multiplier by one of a corresponding number of filter coefficients c₀ through c₄. The results of the multiplication are then passed to a plurality of adders 13 which compute the output signal y (z-transform Y(z)) by summing all results of the multiplication. The transfer function H(z)=Y(z)/X(z) can be constructed easily from the block diagram of the filter as is well-known in the art. The filter is called a finite impulse-response filter as opposed to infinite impulse-response filters because an input pulse having a width of a single sample will produce an output signal (impulse-response) of a finite length which is due to the limited number of stages and the lack of a feedback which would be required to generate any kind of oscillation.

Generally, a digital filter such as the FIR-filter of Fig. 1 can be equivalently realised using a DSP executing a multiply or multiply-accumulate instruction for each filter coefficient on a ring buffer buffering the input samples or similar means. Thus, in the scope of this document a "filter" does not necessarily refer to dedicated hardware only but can be realised in form of software running on a DSP. In addition, a "delay" may refer to a delay of a single clock cycle or any number of clock cycles or in the field of image processing to a pixel, a line of image data or a field or a frame of image data depending on the application of the digital filter and the filtering method.

Fig. 2 shows a first embodiment of the invention. A digital filter 20 according to the invention comprises first and second FIR-filters 21 and 22 whose outputs are selectively connected to the output of the digital filter 20 through a switch 23. The first FIR-filter 21 comprises less stages than the second FIR-filter 22 such that the delay an input sample experiences while being passed through the filter stages is shorter for the first FIR-filter 21 than for the second FIR-filter 22. Thus, output samples resulting from e.g. a input value higher than the surrounding samples will appear at the output of the first FIR-filter 21 earlier than in the case of the second FIR-filter 22. For this reason according to the invention a delay buffer 24 is connected between the input of the digital filter and the input of the first FIR-filter 21 to compensate for the different delays of the two FIR-filters 21 and 22.

Fig. 3 shows a first preferred embodiment of the invention. The digital filter 30 of Fig. 3 has the same structure with a first FIR-filter 31, a second FIR-filter 32, a switch 33 for connecting one of the outputs of the first and second FIR-filters 31 and 32 to the output of the digital filter 30, and a delay buffer 34. In this specific embodiment both the first FIR-filter 31 and the second FIR-filter 32 comprise an odd number of stages, in the case of the first FIR-filter 31 five stages and in the case of the second FIR-filter 32 seven stages. The delay buffer 34 delays the input samples by one clock cycle such that the delay caused by the delay buffer 34 is exactly half the difference of the number of stages of the first and second FIR-filters 31 and 32. Alternatively the first and second FIR-filters 31 and 32 could both have an even number of stages, e.g. 8 and 12 stages. In this case the delay buffer 34 would have (12 - 8)/2 = 2 stages and thus would delay the input samples by two clock cycles.

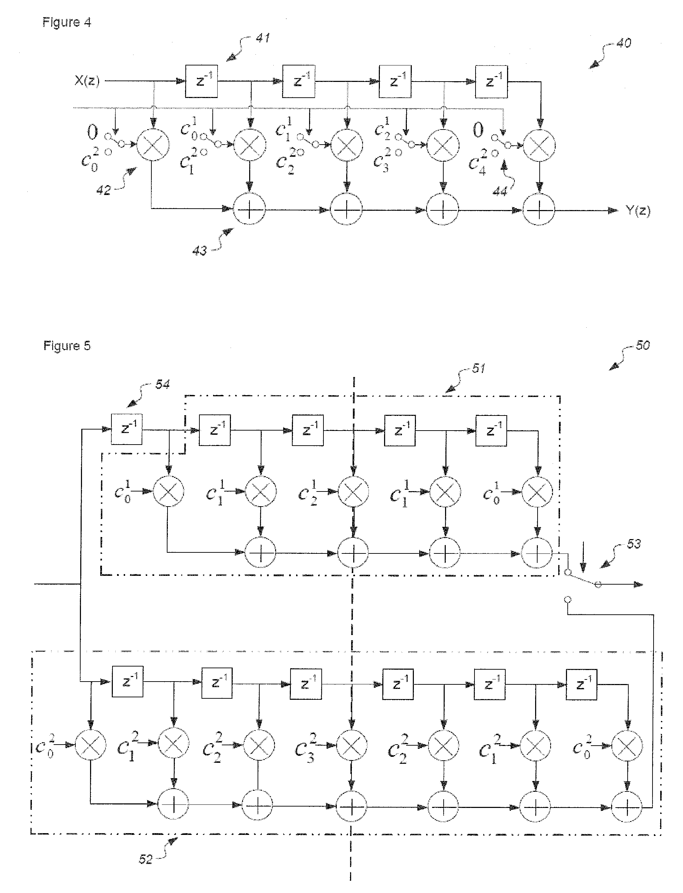

Fig. 4 shows a second preferred embodiment of the invention. The second preferred embodiment 40 represents a simplified design which can be applied to all embodiments of the invention. Here the first and second FIR-filters share a single set of series-connected delays 41. The number of delays 41 is equal to the number of stages of the more complex FIR-filter comprising more stages, i.e. the second FIR-filter. In the example of Fig. 4 the second FIR-filter comprises four stages while the first FIR-filter comprises only two. The outputs and inputs of the delays 41 are connected to a corresponding number multipliers 42 which are adapted to multiply the corresponding input samples by a selected set of filter coefficients. As in Fig. 1 the outputs of the multipliers 42 are summed by a plurality of adders 43 to yield the output signal. In the embodiment of Fig. 4 the output of the digital filter is directly connected to the output of the last adder, i.e. there is no switch for selecting one of the outputs of the first FIR-filter or the second FIR-filter. This is because the first and second FIR-filter share the same hardware. The switching between the two different filters is achieved by selecting an appropriate set of filter coefficients. In the embodiment of Fig. 4 switches 44 allow choosing one of two sets of filter coefficients to be applied to the input samples by the multipliers 42. Since the first and last filter coefficients of the first set of filter coefficients are zero, the first and last multipliers 42 will always produce a result of zero and will not contribute to the result of the filtering operation. Thus, the first FIR-filter resulting from selection of the first set of filter coefficients effectively comprises less stages (in the example of Fig. 4 two stages instead of four). In this case the stages at the input of the digital filter 40 perform the function of the input delay buffer and delay the input samples as required for the production of minimum discontinuities when performing instantaneous switching from one filter characteristic to the other. If the second set of filter coefficients is selected, the digital filter will operate as a normal FIR-filter and all stages will contribute to the filtering operation. The embodiment of Fig. 4 may, of course, be equivalently realised in software changing the set of filter coefficients used in the filtering operation performed by the DSP. The embodiment of Fig. 4 can be seen as a dynamically scalable filter where the number of coefficients and the coefficients themselves can be changed on-the-fly.

Fig. 5 shows a third preferred embodiment of the invention. The third preferred embodiment 50 again comprises a first FIR-filter 51, a second FIR-filter 52, a switch 53 to select an output of either the first FIR-filter 51 or of the second FIR-filter 52, and an input delay buffer 54. In the example of Fig. 5 both FIR-filters 51 and 52 comprise an even number of stages. The additional advantage of the digital filter 50 is the selection of filter coefficients in the first and second FIR-filters 51 and 52 which are symmetric to a middle-axis of the FIR-filters 51, 52. l.e., the first filter coefficient is the same as the last filter coefficient, the second filter coefficient is the same as the last-but-one filter coefficient and so on. This ensures that both FIR-filters are linear-phase FIR-filters. In Fig. 5 it becomes obvious that the number of stages of the input delay buffer 54 should be selected such that it is equal to half the difference of stages between the number of stages of the first and second FIR-filters 51, 52. Thus, the total number of stages from the input of the digital filter to the symmetry axis of the FIR-filters 51, 52 becomes equal (three in the case of Fig. 5). If both FIR-filters comprise either odd or even numbers of stages, the delay difference between the two FIR-filters can be completely compensated. If one of the two FIR-filters 51, 52 has an odd number of stages and the other an even number of stages, half a clock cycle of difference will remain. However, the deterioration of the output signal when switching from the first to the second FIR-filter or vice versa will be tolerable for most set ups.

The invention is of special interest to the field of scalable decimation and interpolation filters which are generally low-pass filters. The invention allows switching of the quality of signal processing and thus of the resources allocated to a specific signal stream without generation of glitches in the output signal. In the case of a decimation filter (conversion from a higher sampling rate to a lower sampling rate, M times lower than the higher sampling rate, wherein M is an integer number), the digital filter of the invention is simply applied to every Mth input sample. In the case of an interpolation filter (conversion from a lower sampling rate to a higher sampling rate, L times higher than the lower sampling rate, wherein L is an integer number) it is advantageous if the number of stages m and n of the first and second FIR-filter, respectively, are integer multiples of L. Decimation and interpolation may both be applied in a single digital filter in order to be able to select a ratio between the overall input sampling rate and the overall output sampling rate of L/M.

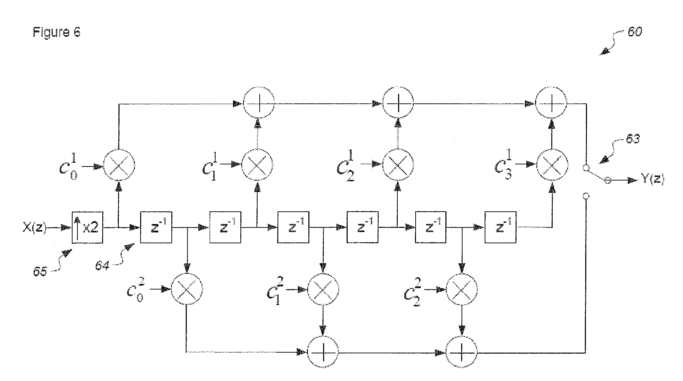

Fig. 6 shows a fourth preferred embodiment of the invention. In the exemplary digital filter 60 shown in Fig. 6 m was chosen to be an even number and n to be an odd number. To be more precise, in the example of Fig. 6 m is 2 and n is 3. At the input of the digital filter 60 an oversampling unit 65 is provided which is adapted to oversample an input data stream. The oversampling ratio in the exemplary embodiment is 2 but may be any number, preferably any even number. For this reason each stage of the digital filter 60 comprises two delays. Since the sampling ratio inside the digital filter 60 is twice that of the original data stream, a delay of an input delay buffer 64 may be set to a delay value corresponding to half a sampling period of the original data stream. Accordingly, a difference between the delays of the two FIR-filters of the digital filter (60) (preferably realised using a single delay chain as explained referring to Fig. 4) can be fully compensated even if m is an even number and n is an odd number (or vice versa).

## Claims

1. A digital filter (20, 30, 40, 50, 60) having an input and an output and comprising a first FIR-filter (21, 31, 51) having m stages (41) and a second FIR-filter (22, 32, 52) having n stages (41) and an input connected to the input of the digital filter (20, 30, 40, 50, 60), wherein m and n are positive integers and n is greater than m, and wherein the output of the digital filter (20, 30, 40, 50, 60) is selectively connectable to one of an output of the first FIR-filter (21, 31, 51) and an output of the second FIR-filter (22, 32, 52) in accordance with a filter selection signal, the digital filter (20, 30, 40, 50, 60) being **characterised by** an input delay buffer (24, 34, 54) connected between the input of the digital filter (20, 30, 40, 50, 60) and an input of the first FIR-filter (21, 31, 51) and having k stages, wherein k is a nearest integer from (n - m)/2.

2. The digital filter (20, 30, 40, 50) of claim 1, wherein both m and n are either odd numbers or even numbers and wherein k is (n - m)/2.

3. The digital filter (60) of claim 1, further including an oversampling unit (65) having an input connected to the input of the digital filter (60) and an output connected to the input of the input delay buffer (64) and to the input of the second FIR-filter, the oversampling unit being adapted to oversample an input data stream, and wherein a first one of m or n is an odd number and a remaining one of m or n is an even number.

4. The digital filter (20, 30, 40, 50, 60) of one of the preceding claims, wherein the first FIR-filter (21, 31, 51) and the second FIR-filter (22, 32, 52) are linear-phase FIR-filters.

5. The digital filter (20, 30, 40, 50, 60) of one of the preceding claims, wherein the first FIR-filter (21, 31, 51) comprises m+1 filter coefficients among which an (i)th filter coefficient is equal to an (m+2-i)th filter coefficient, and wherein the second FIR-filter (22, 32, 52) comprises n+1 filter coefficients among which an (j)th filter coefficient is equal to an (n+2-j)th filter coefficient.
The digital filter (20, 30, 40, 50, 60) of one of the preceding claims, wherein the first FIR-filter (21, 31, 51) and the second FIR-filter (22, 32, 52) are low-pass filters, wherein a cut-off frequency of the first FIR-filter (21, 31, 51) differs by less than thirty percent from a cut-off frequency of the second FIR-filter (22, 32, 52) or wherein the cut-off frequency of the first FIR-filter (21, 31, 51) is equal to the cut-off frequency of the second FIR-filter (22, 32, 52).

6. The digital filter (20, 30, 40, 50, 60) of one of the preceding claims, wherein the digital filter (20, 30, 40, 50) is an interpolation filter having an output sampling rate L times higher than an input sampling rate of the digital filter (20, 30, 40, 50, 60), wherein L is an integer number and k is an integer multiple of L, or wherein the digital filter (20, 30, 40, 50, 60) is a decimation filter having an output sampling rate M times lower than an input sampling, wherein M is an integer multiple of k.

7. A method of digital filtering an input data stream having an input sampling rate to create an output data stream comprising:
filtering the input data stream with a first FIR-filter function having m stages, wherein m is a positive interger;
filtering the input data stream with a second FIR-filter function having n stages, wherein n is a positive integer greater than m;
selectively outputting an output of the first FIR-filter function or the second FIR-filter function in accordance with a filter selection signal;
**characterised in that** the input data stream is delayed by k input samples, wherein k is a nearest integer from (n - m)/2, before being passed to the first FIR-filter function.

8. The method of claim 8, wherein both m and n are either odd numbers or even numbers and wherein k is (n - m)/2.

9. The method of claim 8, comprising oversampling an input data stream, wherein a first one of m or n is an odd number and a remaining one of m or n is an even number.

10. The method of one of the claims 8 through 10, wherein the first FIR-filter function and the second FIR-filter function are linear-phase FIR-filter functions.

11. The method of claim 11, wherein the first FIR-filter function comprises m+1 filter coefficients among which an (i)th filter coefficient is equal to an (m+2-i)th filter coefficient and wherein the second FIR-filter function comprises n+1 coefficients among which an (j)th coefficient is equal to an (n+2-j)th coefficient.
The method of one of the claims 8 through 12, wherein the first FIR-filter function and the second FIR-filter function are low-pass filter functions, wherein a cut-off frequency of the first FIR-filter function differs by less than thirty percent from a cut-off frequency of the second FIR-filter function or wherein the cut-off frequency of the first FIR-filter function is equal to the cut-off frequency of the second FIR-filter function.

12. The method of one of the claims 8 through 13, comprising interpolating the input data stream to create an output data stream having an output sampling rate L times higher than the input sampling rate, wherein L is an integer number and k is an integer multiple of L, or comprising decimating the input data stream to create an output data stream having an output sampling rate M times lower than the input sampling rate, wherein M is an integer multiple of k.

13. A computer-readable storage medium storing a computer-executable program which causes a computer executing the computer-executable program to carry out the method of one of the claims 8 through 14.
